**Europäisches Patentamt**

**European Patent Office**

**Office européen des brevets**

(11) Veröffentlichungsnummer: **0 421 248 A2**

# (12) EUROPÄISCHE PATENTANMELDUNG

(21) Anmeldenummer: 90118426.7

(22) Anmeldetag: 26.09.90

(51) Int. Cl.5: **H01L 31/048**

(30) Priorität: 06.10.89 DE 3933402

(43) Veröffentlichungstag der Anmeldung:
10.04.91 Patentblatt 91/15

(84) Benannte Vertragsstaaten:
**DE FR GB IT**

(71) Anmelder: **Nukem GmbH**
**Rodenbacher Chaussee 6 Postfach 11 00 80**
**W-6450 Hanau 11(DE)**

(72) Erfinder: **Hoffmann, Winfried, Dipl.-Phys. Dr.**
**Bergstrasse 48**
**W-6450 Hanau 7(DE)**
Erfinder: **Liesenfeld, Manfred**
**Rhönstrasse 5**
**W-8755 Alzenau-Wasserlos(DE)**
Erfinder: **Luthardt, Günther, Dipl.-Chem. Dr.**
**Goethestrasse 7**
**W-6458 Rodenbach 4(DE)**
Erfinder: **Schum, Berthold, Chem.-Ing.**
**Bornweg 44**
**W-6465 Biebergemünd(DE)**

(54) **Solarmodul.**

(57) Großflächiges Solarmodul aus mehreren photovoltaischen Solarzellen zwischen einer frontseitigen Glasplatte und einer rückseitigen Abdeckung. Die Zwischenräume sind mit einem härtbaren, optisch voll transparenten Harz ausgegossen.

EP 0 421 248 A2

## SOLARMODUL

Die Erfindung betrifft ein Solarmodul, bestehend aus mehreren in Reihen angeordneten photovoltaischen Solarzellen, welche mit Abstandshaltern auf der Rückseite versehen zwischen einer entsprechend dimensionierten frontseitigen Glasplatte und einer rückseitigen Abdeckung fixiert sind.

Solarmodule gewinnen weltweit an Bedeutung. Neben die bisher üblicherweise eingesetzten Module mit Abmessungen typischerweise von ca. 1 m x 0,5 m als Obergrenze treten mehr und mehr großflächige Solarfelder mit Spitzenleistungen von 100 Watt bis zu mehreren 100 Kilowatt mit dem Ziel, die erzeugte elektrische Energie in Stromnetze einzuspeisen.

Mit dem Übergang zu großflächigen Solarfeldern wird auch die Forderung nach großflächigen leicht aneinander reihbaren Solarmodulen gestellt, die kostengünstiger mit niedrigeren spezifischen Kosten pro Wattpeak gefertigt werden können.

Solarmodule werden üblicherweise durch Laminieren von Solarzellen mit Hilfe einer Kunststoffolie auf Glas oder kunststoffbeschichtetes Aluminium im Autoklaven hergestellt. Diese Fertigungsweise kann bei zu geringem Anpreßdruck zu Blasen im Laminat, bei zu hohem Anpreßdruck zu Brüchen führen. Den Abmessungen sind durch diese Fertigungstechnik daher Grenzen gesetzt.

Bei kleineren Abmessungen der Solarmodule ist es auch bekannt, die Solarzellen zwischen zwei Glasscheiben zu fixieren. Bei großflächigen Solarmodulen gab es bisher allerdings Schwierigkeiten bei der Fixierung der einzelnen Solarzellen.

Es war daher Aufgabe der vorliegenden Erfindung, ein Solarmodul, bestehend aus mehreren in Reihen angeordneten photovoltaischen Solarzellen zu entwickeln, welche mit Abstandshaltern auf der Rückseite versehen zwischen einer entsprechend dimensionierten frontseitigen Glasplatte und einer rückseitigen Abdeckung fixiert sind und ohne nennenswerten Ausschuß hergestellt werden können.

Diese Aufgabe wird erfindungsgemäß dadurch gelöst, daß der Zwischenraum zwischen Frontglas und rückseitiger Abdeckung mit einem härtbaren, optisch voll transparenten Harz ausgegossen ist.

Vorzugsweise verwendet man als härtbares Harz ein niedrigviskoses (Meth)-Acrylatharz, dem vorteilhafterweise UV-absorbierende Substanzen zugesetzt sind. Außerdem ist es günstig, auch für die rückwärtige Abdeckung eine Glasplatte zu verwenden.

Die Solarzellen werden über Abstandshalter auf der rückseitigen Abdeckung fixiert und über weitere Abstandshalter in einem definierten Abstand zur Frontglasscheibe gehalten. Der so gegebene Zwischenraum wird mit einem niedrigviskosen Gießharz, beispielsweise zwischen 20 und 100 cP, ausgegossen, das nachfolgend aushärtet und so die Solarzellen exakt fixiert. Vorzugsweise verwendet man ein Harz auf (Meth)-Acrylatbasis, dem eigenschaftsverbessernde Substanzen zugegeben werden können.

So lassen sich durch an sich bekannte Zusätze in definierten Mengen die UV-Anteile der Sonneneinstrahlung auf sehr niedrige Werte bis an die Meßgrenze reduzieren, durch andere Zusätze der Brechungsindex "n" für das Gesamtsystem optimieren und durch weitere Zusätze eine besondere Haftung des Harzes am Glas zur Vermeidung späteren Delaminierens erzielen.

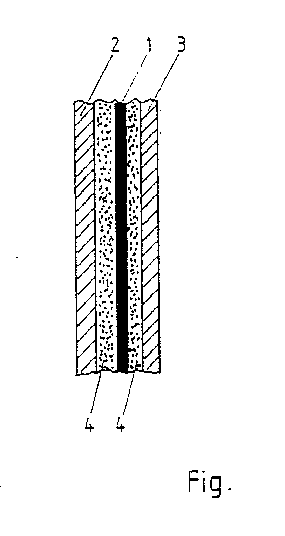

Die Abbildung zeigt schematisch einen Längsschnitt durch eine beispielhafte Ausführungsform des erfindungsgemäßen Solarmoduls im Ausschnitt. Die Solarzelle (1) ist zwischen einer frontseitigen Glasplatte (2) und einer rückseitigen Glasplatte (3) angeordnet. Die Zwischenräume zwischen Solarzelle (1) und Glasplatten (2, 3) sind mit einem härtbaren, optisch volltransparenten Harz (4) ausgegossen.

## Ansprüche

1. Solarmodul, bestehend aus mehreren in Reihen angeordneten photovoltaischen Solarzellen, welche mit Abstandshaltern auf der Rückseite versehen zwischen einer entsprechend dimensionierten frontseitigen Glasplatte und einer rückseitigen Abdeckung fixiert sind, dadurch gekennzeichnet, daß der Zwischenraum zwischen dem Frontglas (2) und der rückseitigen Abdeckung (3) mit einem härtbaren, optisch volltransparenten Harz (4) ausgegossen ist.

2. Solarmodul nach Anspruch 1, dadurch gekennzeichnet, daß als härtbares Harz (4) ein niedrigviskoses (Meth)-Acrylatharz verwendet wird.

3. Solarmodul nach Anspruch 1 und 2, dadurch gekennzeichnet, daß dem Harz (4) UV-absorbierende Substanzen zugesetzt sind.

4. Solarmodul nach Anspruch 1 bis 3, dadurch gekennzeichnet, daß die rückseitige Abdeckung (3) aus einer Glasplatte besteht.

2    1    3

Fig.

4    4